# FASCICULE DE BREVET EUROPEEN

(11) **EP 0 777 321 B1**
(45) Date de publication et mention de la délivrance du brevet: **10.10.2001**
(21) Numéro de dépôt: 96203266.0
(22) Date de dépôt: 21.11.1996
(51) Int. Cl.: H03F 1/32, H03F 3/45

(54) **Amplification de tension à large plage de variation et convertisseur analogique/numérique comportant un tel amplificateur**
Verstärkung einer Spannung mit grossem Veränderungsbereich und diesen Verstärker enthaltender Analog-Digitalumsetzer
Amplification of a voltage having wide variation and A-D converter comprising such an amplifier

(30) Priorité: 29.11.1995 FR 9514130
(43) Date de publication de la demande: 04.06.1997
(73) Titulaire: Koninklijke Philips Electronics N.V., 5621 BA Eindhoven (NL)
(72) Inventeur: Guyot, Benoît, 75008 Paris (FR)
(74) Mandataire: Charpail, François

(56) Documents cités:
- EP-A- 0 312 017

## Description

La présente invention concerne un amplificateur de tension, destiné à recevoir une tension d'entrée et à fournir une tension de sortie, comportant un étage amplificateur incluant un premier et un deuxième transistors montés en paire différentielle, la base du premier transistor étant destinée à recevoir la tension d'entrée, la base du deuxième transistor étant destinée à recevoir une tension opposée à ladite tension d'entrée, le collecteur du premier transistor étant relié à une borne positive d'alimentation par une première branche comportant une charge résistive, le collecteur du deuxième transistor, destiné à fournir la tension de sortie, étant relié à la borne positive d'alimentation par une deuxième branche comportant une charge résistive.

Un tel amplificateur de tension est décrit dans le brevet américain n°4,904,952. Cet amplificateur de tension connu fournit un fort gain en tension, tout en ayant un bon comportement en fréquence. On constate toutefois que sa caractéristique de transfert perd de sa linéarité au voisinage des limites de la plage de variation de la tension de sortie. De plus, le nombre d'étages de transistors étant au minimum de trois entre les deux potentiels d'alimentation du circuit, cette plage de variation est nécessairement réduite, ce qui présente un inconvénient majeur dans les applications "basse tension".

La présente invention a pour but de remédier à ces inconvénients, en proposant un amplificateur de tension dont la linéarité de la caractéristique de transfert est améliorée au voisinage des limites de la plage de variation de la tension de sortie, tout en présentant un nombre limité d'étages de transistors entre les deux potentiels d'alimentation du circuit.

En effet, selon la présente invention, un amplificateur de tension du type défini dans le paragraphe introductif est caractérisé en ce que la deuxième branche est formée d'au moins deux éléments résistifs montés en série présentant ainsi entre eux au moins un premier noeud intermédiaire entre la borne positive d'alimentation et le collecteur du deuxième transistor, en ce qu'il est muni d'une troisième branche comportant un élément résistif placé en série avec une source de courant, laquelle troisième branche est disposée entre la borne positive d'alimentation et une borne négative d'alimentation et présente entre l'élément résistif et la source de courant un deuxième noeud intermédiaire, et en ce qu'il est muni de moyens pour effectuer une comparaison entre le potentiel du deuxième noeud intermédiaire et celui du collecteur du premier transistor d'une part, et entre le potentiel du deuxième noeud intermédiaire et celui du collecteur du deuxième transistor d'autre part, et pour ajouter au courant débité dans une portion de la charge résistive de la deuxième branche, un premier courant qui s'annule progressivement lorsque le potentiel du collecteur du premier transistor devient inférieur à celui du deuxième noeud intermédiaire et un second courant qui s'annule progressivement lorsque le potentiel du collecteur du deuxième transistor devient supérieur à celui du deuxième noeud intermédiaire.

Un mode de réalisation particulièrement avantageux de l'invention présente un amplificateur de tension caractérisé en ce que les moyens de comparaison entre le potentiel du deuxième noeud intermédiaire et celui du collecteur du premier transistor d'une part, et entre le potentiel du deuxième noeud intermédiaire et celui du collecteur du deuxième transistor d'autre part comprennent respectivement un troisième et un quatrième transistors montés en paire différentielle d'une part, un cinquième et un sixième transistors montés en paire différentielle d'autre part, la base du troisième transistor étant reliée au collecteur du premier transistor, celle du quatrième transistor au deuxième noeud intermédiaire, la base du cinquième transistor étant reliée au collecteur du deuxième transistor, celle du sixième transistor au deuxième noeud intermédiaire, les collecteurs des troisième et sixième transistors étant reliés au premier noeud intermédiaire.

Les paires différentielles additionnelles étant montées en parallèle avec l'étage amplificateur, l'amplificateur présente ainsi un nombre limité d'étages à transistors entre les deux bornes d'alimentation du circuit, la somme des chutes de tension aux bornes des divers transistors étant par conséquent elle aussi limitée, ce qui rend l'amplificateur particulièrement adapté aux applications "basses tensions".

Une variante de l'invention permet de régler les seuils de comparaison, sans pour autant modifier de manière significative le gain de l'amplificateur, afin de limiter les effets de la correction apportée à la tension de sortie aux seules plages de variation où cette dernière évolue de manière non-linéaire.

Un tel amplificateur de tension est caractérisé en ce que l'élément résistif séparant la borne positive d'alimentation du premier noeud intermédiaire et l'élément résistif compris dans la troisième branche ont une valeur voisine, et en ce que le courant débité par la source de courant comprise dans la troisième branche a une valeur voisine de la valeur maximale du courant passant dans le deuxième transistor.

Un amplificateur de tension selon une autre variante de l'invention est caractérisé en ce que l'élément résistif séparant le premier noeud intermédiaire de la borne positive d'alimentation a une valeur inférieure à celle de l'élément résistif séparant le premier noeud intermédiaire du collecteur du deuxième transistor.

La portion de la charge résistive dans laquelle circulent, en plus du courant de fonctionnement normal de l'étage amplificateur, le ou les courants ajoutés par les paires différentielles additionnelles, étant limitée, la chute de tension provoquée par le ou les courants ajoutés par les paires différentielles additionnelles est ainsi limitée à un simple effet correcteur.

Un amplificateur selon l'invention présente, outre l'avantage de disposer d'une caractéristique de transfert à linéarité améliorée sur une plus large plage de variation de la tension d'entrée, celui de fournir une sortie unique, non différentielle, ce qui le rend particulièrement adapté à des applications de type conversion analogique/numérique, où la tension de sortie de l'amplificateur est comparée à une gamme de tensions de référence, elles aussi de nature non différentielle.

L'invention concerne donc également un convertisseur analogique/numérique, destiné à recevoir une tension d'entrée analogique de nature différentielle à convertir en un signal de sortie numérique, comprenant :
. un amplificateur d'entrée destiné à recevoir la tension d'entrée analogique et à fournir une tension de sortie analogique,
. une échelle de résistances placées en série entre une borne positive et une borne négative d'alimentation, résistances destinées à fournir à leurs noeuds intermédiaires une pluralité de tensions dites de référence,
. un étage de comparateurs, chacun destiné à effectuer une comparaison de la tension de sortie de l'amplificateur d'entrée avec l'une des tensions de référence,
. un étage de mémorisation destiné à mémoriser les résultats desdites comparaisons,
. un encodeur binaire, destiné à recevoir les informations mémorisées dans l'étage de mémorisation et à fournir le signal de sortie numérique du convertisseur,
caractérisé en ce que l'amplificateur d'entrée est tel que décrit plus haut.

L'invention sera mieux comprise à l'aide de la description suivante de quelques modes de réalisation de l'invention, faite à titre d'exemple, et en regard des dessins annexés, dans lesquels :
- la figure 1 est un schéma fonctionnel partiel d'un amplificateur de tension selon l'invention,
- la figure 2 est un schéma fonctionnel partiel d'un amplificateur de tension selon un mode de réalisation avantageux de l'invention,
- la figure 3 est un ensemble de caractéristiques décrivant l'évolution des potentiels des collecteurs des premier et deuxième transistors, en fonction de la tension d'entrée de l'amplificateur,
- la figure 4 est une caractéristique décrivant l'évolution du premier courant ajouté dans une portion de la charge résistive, en fonction de la tension d'entrée de l'amplificateur,
- la figure 5 est une caractéristique décrivant l'évolution du deuxième courant ajouté dans une portion de la charge résistive, en fonction de la tension d'entrée de l'amplificateur,
- la figure 6 est un ensemble de caractéristiques décrivant l'évolution du courant dans ladite portion de la charge résistive, en fonction de la tension d'entrée de l'amplificateur,
- la figure 7 est une caractéristique décrivant l'évolution de la tension de sortie, en fonction de la tension d'entrée de l'amplificateur,
- la figure 8 est une caractéristique décrivant l'évolution de la dérivée de la tension de sortie, en fonction de la dérivée de la tension d'entrée de l'amplificateur, et
- la figure 9 est un schéma fonctionnel partiel d'un convertisseur analogique/numérique comprenant un amplificateur de tension selon l'invention,

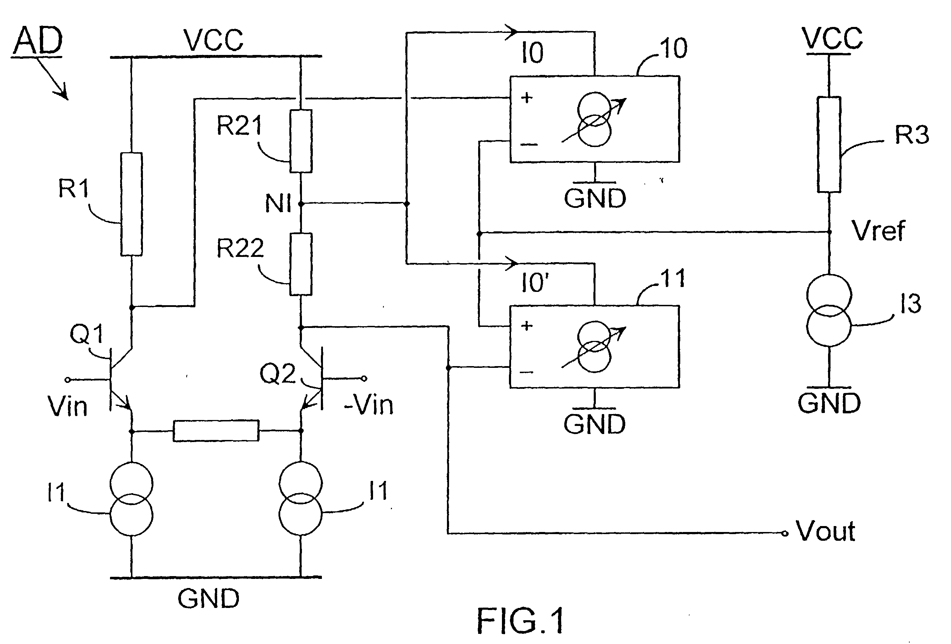

La figure 1 décrit schématiquement un amplificateur de tension AD selon l'invention. Deux transistors Q1 et Q2 sont montés en paire différentielle : l'émetteur du transistor Q1 est relié à une des bornes d'une résistance, l'émetteur du transistor Q2 étant relié à l'autre borne de la même résistance. Chacun des deux émetteurs est relié à une borne d'une source de courant I1, l'autre borne de ladite source de courant étant reliée à une borne négative d'alimentation, appelée GND. La base du transistor Q1 reçoit la tension d'entrée de l'amplificateur de tension, appelée Vin, la base du transistor Q2 recevant l'opposée de ladite tension d'entrée, soit -Vin. Le collecteur du premier transistor Q1 est relié à une borne positive d'alimentation, appelée VCC, par une première branche comportant une charge résistive, le collecteur du deuxième transistor Q2, fournissant la tension de sortie appelée Vout, étant relié à la borne positive d'alimentation VCC par une deuxième branche comportant une charge résistive. La première branche est formée d'un élément résistif R1. La deuxième branche est formée d'au moins deux éléments résistifs, appelés R21 et R22, montés en série et présentant entre eux au moins un premier noeud intermédiaire, appelé NI, entre la borne positive d'alimentation VCC et le collecteur du deuxième transistor Q2.

L'amplificateur de tension AD est muni d'une troisième branche comportant un élément résistif R3 placé en série avec une source de courant I3, laquelle troisième branche est disposée entre la borne positive d'alimentation VCC et la borne négative d'alimentation GND et présente entre l'élément résistif R3 et la source de courant I3 un deuxième noeud intermédiaire. L'amplificateur de tension est en outre muni de moyens 10 et 11 pour effectuer une comparaison entre le potentiel du deuxième noeud intermédiaire, appelé Vref, et celui du collecteur du premier transistor Q1 d'une part, et entre le potentiel du deuxième noeud intermédiaire Vref et celui du collecteur du deuxième transistor Q2 d'autre part. Ces mêmes moyens permettent d'ajouter au courant débité dans une portion de la charge résistive de la deuxième branche, un premier courant I0 qui s'annule progressivement lorsque le potentiel du collecteur du premier transistor Q1, appelé VC1, devient inférieur à Vref, et un second courant I0' qui s'annule progressivement lorsque le potentiel du collecteur du deuxième transistor Q2, appelé VC2, devient supérieur à Vref.

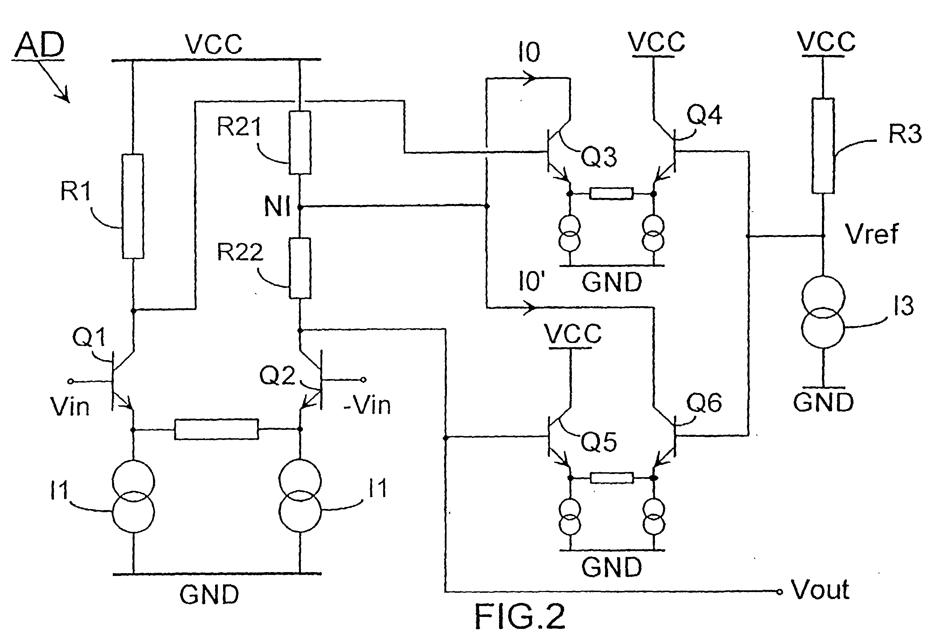

La figure 2 décrit schématiquement un amplificateur de tension AD selon un mode de réalisation avantageux de l'invention. Les structures de l'étage amplificateur et des branches comportant les charges résistives sont identiques à celles décrites par la figure 1. Un mode de réalisation des moyens 10 et 11 y est en outre exposé : ils comprennent respectivement un troisième transistor Q3 et un quatrième transistor Q4, montés en paire différentielle, et un cinquième transistor Q5 et un sixième transistor Q6, montés en paire différentielle. La base du troisième transistor Q3 est reliée au collecteur du premier transistor Q1, celle du quatrième transistor Q4 au deuxième noeud intermédiaire, la base du cinquième transistor Q5 est reliée au collecteur du deuxième transistor Q2, celle du sixième transistor Q6 au deuxième noeud intermédiaire. Les collecteurs des troisième et sixième transistors Q3 et Q6 sont reliés au premier noeud intermédiaire NI, et ceux des quatrième et cinquième transistors Q4 et Q5 à la borne positive d'alimentation VCC.

Dans ce mode de réalisation, l'élément résistif R21 et l'élément résistif R3 compris dans la troisième branche ont une valeur voisine, et le courant débité par la source de courant I3 a une valeur voisine de la valeur maximale du courant passant dans le deuxième transistor Q2, laquelle est de l'ordre de 2.I1. En outre, l'élément résistif R21 a une valeur inférieure à celle de l'élément résistif R22. On choisit R21 inférieur à R22/10, de sorte que la chute de tension aux bornes de R21 ne provoque qu'un effet correcteur sur la tension de sortie Vout. Enfin, pour des raisons de symétrie de fonctionnement de l'amplificateur, la valeur de la charge résistive de la première branche R1 est égale à la somme des valeurs des éléments résistifs R21 et R22 composant la charge résistive de la deuxième branche.

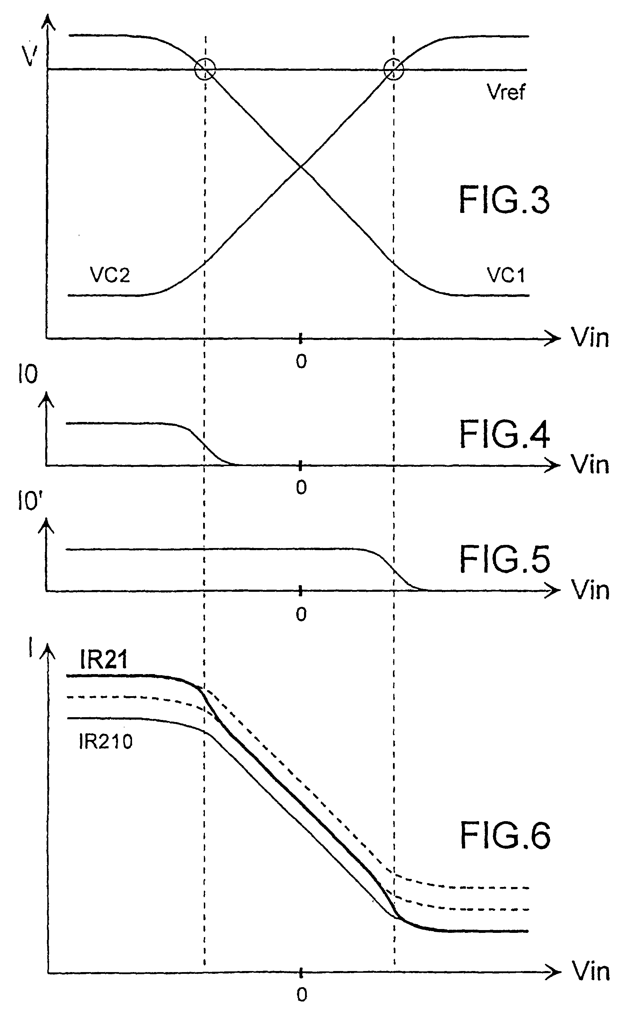

Les figures 3 à 7 décrivent l'évolution de divers signaux internes à l'amplificateur AD en fonction de la tension d'entrée de celui-ci, afin de faciliter la compréhension de son fonctionnement.

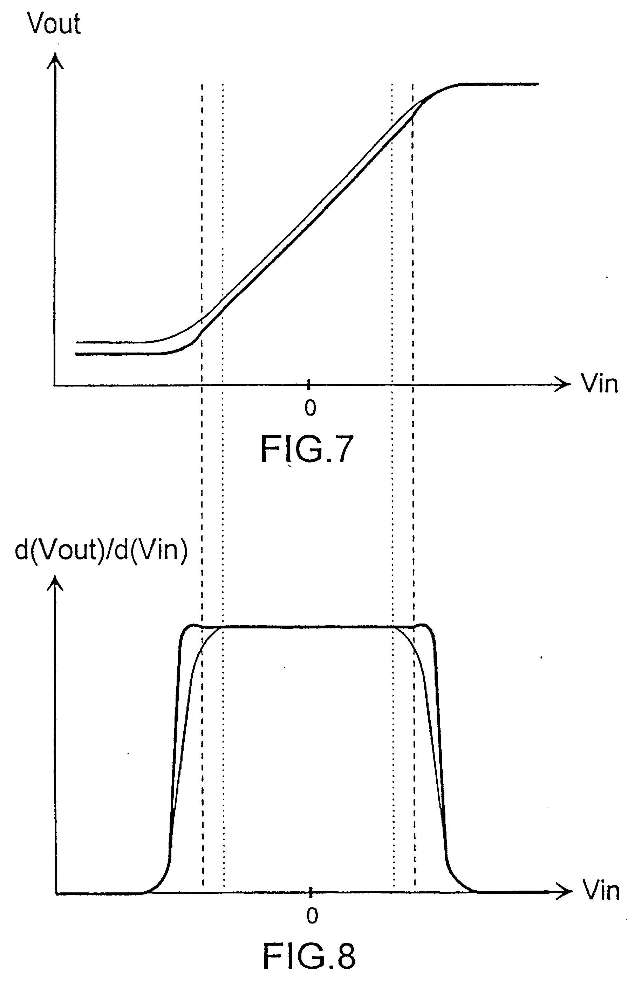

La figure 3 décrit l'évolution des potentiels VC1 et VC2, en fonction de la tension d'entrée Vin de l'amplificateur AD. Les figures 4 et 5 décrivent l'évolution des premier et deuxième courants, respectivement I0 et I0', ajoutés dans une portion de la charge résistive, dans ce cas R21, en fonction de la tension d'entrée Vin de l'amplificateur AD. La figure 6 décrit l'évolution du courant total dans ladite portion de la charge résistive R21 en fonction de la tension d'entrée Vin de l'amplificateur AD. La courbe IR210 y représente le courant qui circulerait dans la deuxième branche si les moyens 10 et 11 n'existaient pas, c'est-à-dire dans le cas de la paire différentielle classique. Les courbes en pointillés y représentent les courants qui circuleraient dans la portion de la charge résistive R21, si, dans un premier cas, la valeur maximale du courant I0 était ajoutée au courant IR210, et si, dans un deuxième cas, la valeur maximale du courant I0' était ajoutée au courant précédemment obtenu. La figure 7 décrit en trait gras l'évolution de la tension de sortie Vout en fonction de la tension d'entrée Vin d'un amplificateur selon l'invention, la courbe en trait fin décrivant, elle, l'évolution de la tension de sortie d'une paire différentielle classique.

Lorsque Vin est négatif et grand en valeur absolue, le transistor Q1 est très peu conducteur alors que le transistor Q2 est très conducteur. Le courant dans la première branche est donc très faible, alors que le courant dans la deuxième branche est important. La chute de tension dans l'élément résistif R1 est négligeable, alors que les chutes de tension dans les éléments résistifs R21 et R22 sont significatives. On observe sur la figure 3 que VC1 est alors nettement supérieur à Vref. Le transistor Q4 est donc peu conducteur alors que le transistor Q3 est très conducteur et fait passer un courant I0 au travers de la résistance R21. Vref étant nettement supérieur à VC2, le transistor Q5 est peu conducteur alors que le transistor Q6 est très conducteur et fait passer un courant I0' supplémentaire au travers de la résistance R21. Le courant total IR21 circulant au travers de la résistance R21 est décrit par la figure 6. Le courant circulant dans la deuxième branche étant à son niveau maximal, la tension de sortie Vout est alors à son niveau le plus bas, comme le montre la figure 7, et la chute de tension additionnelle générée dans R21 par les courants ajoutés I0 et I0' explique la différence de valeur entre le niveau bas de la tension de sortie Vout d'un amplificateur selon l'invention et celui de la tension de sortie de la paire différentielle classique.

Lorsque Vin augmente, tout en restant négatif, la première zone de fonctionnement non-linéaire de l'étage amplificateur classique est atteinte : le transistor Q1 conduit plus, alors que le transistor Q2 conduit moins, le courant circulant dans la première branche augmente alors que le courant circulant dans la deuxième branche diminue. Les potentiels VC1 et Vref se rapprochent, augmentant la conduction de Q4 et diminuant la conduction de Q3, provoquant l'annulation progressive du courant I0 passant au travers de la résistance R21.

Tout au long de la portion linéaire, qui correspond au changement de signe de Vin, le transistor Q5 reste peu conducteur alors que le transistor Q6 reste très conducteur, et maintient la circulation du courant I0' au travers de la résistance R21.

Lorsque Vin augmente, la deuxième zone de fonctionnement non-linéaire de l'étage amplificateur classique est atteinte : le transistor Q1 conduit encore plus alors que le transistor Q2 conduit encore moins, le courant circulant dans la première branche augmente alors que le courant circulant dans la deuxième branche diminue. Les potentiels VC2 et Vref se rapprochent, augmentant la conduction de Q5 et diminuant la conduction de Q6, provoquant l'annulation progressive du courant I0' passant au travers de la résistance R21.

Enfin, lorsque Vin est grand, le transistor Q2 est très peu conducteur alors que le transistor Q1 est très conducteur. Le courant dans la deuxième branche est donc très faible, alors que le courant dans la première branche est important. La chute de tension dans l'élément résistif R1 est significative, alors que les chutes de tension dans les éléments résistifs R21 et R22 sont négligeables. La tension de sortie Vout est alors à son niveau le plus haut, comme le montre la figure 7.

Cette figure montre l'influence des paires additionnelles de transistors dans les zones de non-linéarité de la caractéristique de la tension de sortie. En effet, dans la première zone non-linéaire, où Vout augmente trop tôt avec Vin dans le cas de la paire différentielle classique, l'ajout des courants I0 et I0' maintient artificiellement Vout au niveau bas plus longtemps, puis la diminution progressive de I0 permet à Vout d'augmenter quasi-linéairement. De même, dans la deuxième zone non-linéaire, où Vout augmente trop lentement avec Vin dans le cas de la paire différentielle classique, l'ajout du courant I0' maintient artificiellement Vout à un niveau intermédiaire plus longtemps, puis la diminution progressive de I0' permet à Vout d'augmenter quasi-linéairement.

De la sorte, la zone où la tension de sortie évolue linéairement en fonction de la tension d'entrée est élargie. On peut observer ce résultat sur la figure 8, où l'on voit deux caractéristiques d(Vin)/d(Vout) en fonction de la tension d'entrée Vin, l'une en trait fin correspondant à une paire différentielle classique, et l'autre en trait gras correspondant à un amplificateur selon l'invention. La partie "plate", où la dérivée de la tension de sortie Vout par rapport à la tension d'entrée Vin est constante, correspond à la partie où la tension de sortie évolue linéairement en fonction de la tension d'entrée. La zone ainsi délimitée est clairement plus large pour un amplificateur de tension selon l'invention que pour une paire différentielle classique.

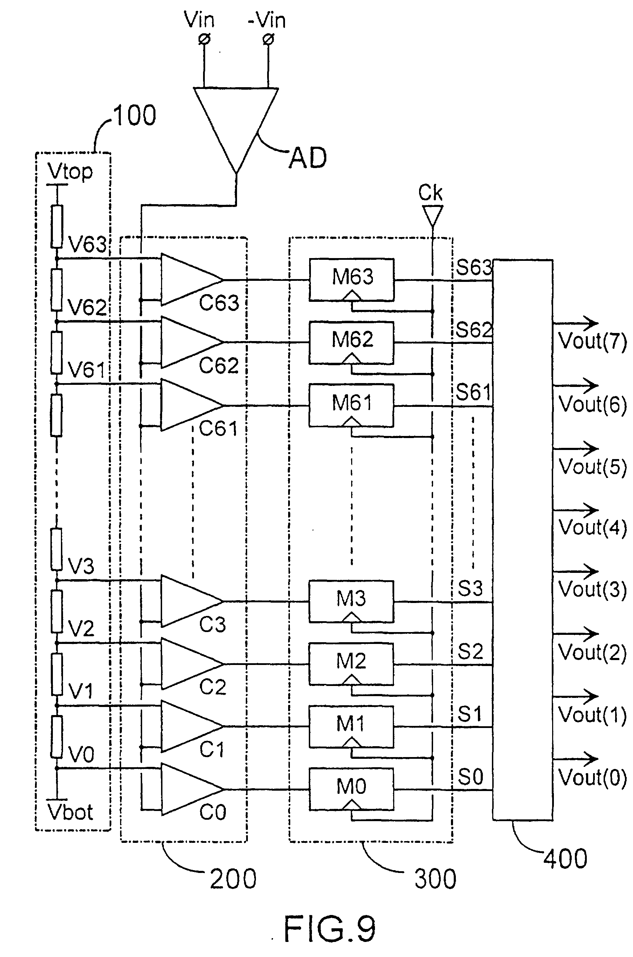

La figure 9 représente partiellement un convertisseur analogique/numérique qui comporte un amplificateur de tension AD conforme à l'une des variantes représentées sur les figures 1 et 2. Dans le cas présent, ce convertisseur reçoit une tension d'entrée analogique de nature différentielle (Vin, -Vin) à convertir en un signal de sortie numérique codé sur 8 bits Vout(0...7). Ce convertisseur comprend :
. l'amplificateur d'entrée AD recevant la tension d'entrée analogique (Vin, -Vin), et fournissant une tension de sortie analogique,
. une échelle de résistances 100, formée de 64 résistances placées en série entre une borne positive et une borne négative d'alimentation, respectivement Vtop et Vbot, résistances fournissant à leurs noeuds intermédiaires 64 tensions dites de référence, V0, V1,...V63, V0 étant égale à Vbot.
. un étage de comparateurs 200, formé de 64 comparateurs, chacun réalisant la comparaison de la tension de sortie de l'amplificateur d'entrée AD avec l'une des tensions de référence V0, V1,...V63,
. un étage de mémorisation 300 composé d'éléments de mémorisation dits cellules mémoire M0, M1,...M63, chaque cellule mémoire Mi (pour i=0 à 63) étant munie d'une entrée de données, d'une sortie et d'une entrée d'horloge, et recevant sur son entrée de données le signal de sortie Ci d'un comparateur, toutes les cellules mémoire M0, M1,...M63 composant l'étage de mémorisation 300 recevant sur leurs entrées d'horloge un même signal Ck dit signal d'horloge,
. un encodeur binaire 400, lequel encodeur 400 reçoit en entrée les sorties S0, S1,...S63 de l'étage de mémorisation 300 et fournit le signal de sortie numérique du convertisseur Vout(0...7).

## Revendications

1. Amplificateur de tension, destiné à recevoir une tension d'entrée et à fournir une tension de sortie, comportant un étage amplificateur incluant un premier et un deuxième transistors montés en paire différentielle, la base du premier transistor étant destinée à recevoir la tension d'entrée, la base du deuxième transistor étant destinée à recevoir une tension opposée à ladite tension d'entrée, le collecteur du premier transistor étant relié à une borne positive d'alimentation par une première branche comportant une charge résistive, le collecteur du deuxième transistor, destiné à fournir la tension de sortie, étant relié à la borne positive d'alimentation par une deuxième branche comportant une charge résistive, amplificateur de tension **caractérisé en ce que** la deuxième branche est formée d'au moins deux éléments résistifs montés en série présentant ainsi entre eux au moins un premier noeud intermédiaire entre la borne positive d'alimentation et le collecteur du deuxième transistor, **en ce qu'**il est muni d'une troisième branche comportant un élément résistif placé en série avec une source de courant, laquelle troisième branche est disposée entre la borne positive d'alimentation et une borne négative d'alimentation et présente entre l'élément résistif et la source de courant un deuxième noeud intermédiaire, **en ce qu'**il est muni de moyens pour effectuer une comparaison entre le potentiel du deuxième noeud intermédiaire et celui du collecteur du premier transistor d'une part, et entre le potentiel du deuxième noeud intermédiaire et celui du collecteur du deuxième transistor d'autre part, et pour ajouter au courant débité dans une portion de la charge résistive de la deuxième branche, un premier courant qui s'annule progressivement lorsque le potentiel du collecteur du premier transistor devient inférieur à celui du deuxième noeud intermédiaire et un second courant qui s'annule progressivement lorsque le potentiel du collecteur du deuxième transistor devient supérieur à celui du deuxième noeud intermédiaire.

2. Amplificateur de tension selon la revendication 1, **caractérisé en ce que** les moyens de comparaison entre le potentiel du deuxième noeud intermédiaire et celui du collecteur du premier transistor d'une part, et entre le potentiel du deuxième noeud intermédiaire et celui du collecteur du deuxième transistor d'autre part comprennent respectivement un troisième et un quatrième transistors montés en paire différentielle d'une part, un cinquième et un sixième transistors montés en paire différentielle d'autre part, la base du troisième transistor étant reliée au collecteur du premier transistor, celle du quatrième transistor au deuxième noeud intermédiaire, la base du cinquième transistor étant reliée au collecteur du deuxième transistor, celle du sixième transistor au deuxième noeud intermédiaire, les collecteurs des troisième et sixième transistors étant reliés au premier noeud intermédiaire.

3. Amplificateur de tension selon l'une quelconque des revendications 1 ou 2, **caractérisé en ce que** l'élément résistif séparant la borne positive d'alimentation du premier noeud intermédiaire et l'élément résistif compris dans la troisième branche ont une valeur voisine, et **en ce que** le courant débité par la source de courant comprise dans la troisième branche a une valeur voisine de la valeur maximale du courant passant dans le deuxième transistor.

4. Amplificateur de tension selon l'une quelconque des revendications 1 à 3, **caractérisé en ce que** l'élément résistif séparant le premier noeud intermédiaire de la borne positive d'alimentation a une valeur inférieure à celle de l'élément résistif séparant le premier noeud intermédiaire du collecteur du deuxième transistor.

5. Amplificateur de tension selon l'une quelconque des revendications 1 à 4, **caractérisé en ce que** la valeur de la charge résistive de la première branche est égale à la somme des valeurs des éléments résistifs composant la charge résistive de la deuxième branche.

6. Amplificateur de tension selon l'une quelconque des revendications 1 à 5, **caractérisé en ce que** les éléments résistifs qui constituent la charge de l'étage amplificateur sont des résistances.

7. Convertisseur analogique/numérique, destiné à recevoir une tension d'entrée analogique de nature différentielle à convertir en un signal de sortie numérique, comprenant :
. un amplificateur d'entrée destiné à recevoir la tension d'entrée analogique, et à fournir une tension de sortie analogique.
. une échelle de résistances placées en série entre une borne positive et une borne négative d'alimentation, résistances destinées à fournir à leurs noeuds intermédiaires une pluralité de tensions dites de référence.
. un étage de comparateurs, chacun destiné à effectuer une comparaison de la tension de sortie de l'amplificateur d'entrée avec l'une des tensions de référence,
. un étage de mémorisation destiné à mémoriser les résultats desdites comparaisons,
. un encodeur binaire, destiné à recevoir les informations mémorisées dans l'étage de mémorisation et à fournir le signal de sortie numérique du convertisseur,
**caractérisé en ce que** l'amplificateur d'entrée est conforme à l'une quelconque des revendications 1 à 6.

## Claims

1. A voltage amplifier intended to receive an input voltage and to supply an output voltage, which voltage amplifier comprises an amplifier stage including a first and a second transistor arranged as a differential pair, the base of the first transistor being intended to receive the input voltage, the base of the second transistor being intended to receive a voltage opposed to said input voltage, the collector of the first transistor being connected to a positive power supply terminal by means of a first branch comprising a resistive load, the collector of the second transistor, intended to supply the output voltage being connected to the positive power supply terminal by means of a second branch comprising a resistive load, **characterized in that** the second branch is constituted by at least two series-arranged resistive elements having at least a first intermediate node between the positive power supply terminal and the collector of the second transistor, **in that** said voltage amplifier is provided with a third branch comprising a resistive element arranged in series with a current source, said third branch being arranged between the positive power supply terminal and a negative power supply terminal and featuring a second intermediate node between the resistive element and the current source, and **in that** the voltage amplifier is provided with means for comparing the potential of the second intermediate node with that of the collector of the first transistor, on the one hand, and the potential of the second intermediate node with that of the collector of the second transistor, on the other hand, and for adding to the current supplied in a portion of the resistive load of the second branch, a first current which is progressively reduced to zero when the potential of the collector of the first transistor falls below that of the second intermediate node, and a second current which is progressively reduced to zero when the potential of the collector of the second transistor exceeds that of the second intermediate node.

2. A voltage amplifier as claimed in claim 1, **characterized in that** the means for comparing the potential of the second intermediate node with that of the collector of the first transistor, on the one hand, and the potential of the second intermediate node with that of the collector of the second transistor, on the other hand, respectively comprise a third and a fourth transistor arranged as a differential pair, on the one hand, and a fifth and a sixth transistor, arranged as a differential pair, on the other hand, the base of the third transistor being connected to the collector of the first transistor and that of the fourth transistor being connected to the second intermediate node, the base of the fifth transistor being connected to the collector of the second transistor and that of the sixth transistor being connected to the second intermediate node, and the collectors of the third and the sixth transistor being connected to the first intermediate node.

3. A voltage amplifier as claimed in claim 1 or 2, **characterized in that** the resistive element between the positive power supply terminal and the first intermediate node and the resistive element comprised in the third branch have substantially the same value, and **in that** the current supplied by the current source comprised in the third branch has a value substantially equal to the maximum value of the current flowing in the second transistor.

4. A voltage amplifier as claimed in any one of claims 1 to 3, **characterized in that** the resistive element between the first intermediate node and the positive power supply terminal has a value which is lower than that of the resistive element between the first intermediate node and the collector of the second transistor.

5. A voltage amplifier as claimed in any one of claims 1 to 4, **characterized in that** the value of the resistive load of the first branch is equal to the sum of the values of the resistive elements constituting the resistive load of the second branch.

6. A voltage amplifier as claimed in any one of claims 1 to 5, **characterized in that** the resistive elements constituting the load of the amplifier stage are resistors.

7. An A/D converter intended to receive an analog input voltage of a differential nature, to be converted into a digital output signal, comprising:
an input amplifier intended to receive the analog input voltage, and to supply an analog output voltage,
a resistance ladder arranged in series between a positive and a negative power supply terminal, in which the resistors are intended to supply a plurality of reference voltages at their intermediate nodes,
a comparator stage in which each comparator is intended to perform a comparison between the output voltage of the input amplifier and one of the reference voltages,
a memory stage intended to store the results of said comparisons, and
a binary encoder intended to receive the information stored in the memory stage and to supply the digital output signal of the converter,
**characterized in that** the input amplifier is an amplifier as claimed in any one of claims 1 to 6.

## Patentansprüche

1. Spannungsverstärker zum Empfangen einer Eingangsspannung und zum Liefern einer Ausgangsspannung, mit einer Verstärkerstufe, die einen ersten und einen zweiten Transistor aufweist, als Differentialpaar geschaltet, während die Basis des ersten Transistors dazu bestimmt ist, die Eingangsspannung zu erhalten, die Basis des zweiten Transistors dazu bestimmt ist, eine zur besagten Eingangsspannung umgekehrte Spannung zu erhalten, der Kollektor des ersten Transistors über eine positive Versorgungsklemme mit einem ersten Zweig verbunden ist, der eine ohmsche Ladung aufweist, der Kollektor des zweiten Transistors, dazu bestimmt, die Ausgangsspannung zu liefern, über eine positive Versorgungsklemme mit einem zweiten Zweig verbunden ist, der eine ohmsche Ladung aufweist, ein **dadurch gekennzeichnet**er Spannungsverstärker, **daß** der erste Zweig aus mindesten zwei in Serie geschalteten ohmschen Elementen gebildet wird, die so zwischen sich mindestens einen ersten Zwischenknoten zwischen der positiven Versorgungsklemme und dem Kollektor des zweiten Transistors bilden, **daß** er mit einem dritten Zweig versehen ist, der ein ohmsches Element aufweist, in Serie mit einer Stromquelle angeordnet, wobei der dritte Zweig zwischen der positiven Versorgungsklemme und einer negativen Versorgungsklemme angeordnet ist und zwischen dem ohmschen Element und der Stromquelle einen zweiten Zwischenknoten aufweist, **daß** er mit Mitteln versehen ist, um einerseits einen Vergleich zwischen dem Potential des zweiten Zwischenknotens und dem des Kollektors des ersten Transistors, und andererseits zwischen dem Potential des zweiten Zwischenknotens und dem des Kollektors des zweiten Transistors vorzunehmen, und um dem in einem Teil der ohmschen Ladung des zweiten Zweigs abgegebenen Strom einen ersten Strom hinzuzufügen, der sich nach und nach aufhebt, wenn das Potential des Kollektors des ersten Transistors unter das des zweiten Zwischenknotens abfällt, und einen zweiten Strom, der sich nach und nach aufhebt, wenn das Potential des Kollektors des zweiten Transistors über das des zweiten Zwischenknotens ansteigt.

2. Spannungsverstärker nach Anspruch 1, **dadurch gekennzeichnet, daß** die Mittel zum Vergleich einerseits des Potentials des zweiten Zwischenknotens mit dem des Kollektors des ersten Transistors und andererseits des Potentials des zweiten Zwischenknotens mit dem des Kollektors des zweiten Transistors respektive einerseits einen dritten und einen vierten, als Differentialpaar geschalteten Transistor, und andererseits einen fünften und einen sechsten, als Differentialpaar geschalteten Transistor enthalten, wobei die Basis des dritten Transistors mit dem Kollektor des ersten Transistors, die des vierten Transistors mit dem zweiten Zwischenknoten verbunden ist, die Basis des fünften Transistors mit dem Kollektor des zweiten Transistors, die des sechsten Transistors mit dem zweiten Zwischenknoten verbunden ist und die Kollektoren des dritten und sechsten Transistors mit dem ersten Zwischenknoten verbunden sind.

3. Spannungsverstärker nach einem beliebigen der Ansprüche 1 oder 2, **dadurch gekennzeichnet daß** das ohmsche Element zur Trennung der positiven Versorgungsklemme vom ersten Zwischenknoten und das im dritten Zweig enthaltene ohmsche Element einen benachbarten Wert haben, und dadurch, daß der von der Stromquelle im dritten Zweig abgegebene Strom einen Wert nahe des maximalen Werts des durch den zweiten Transistor kommenden Stroms hat.

4. Spannungsverstärker nach einem beliebigen der Ansprüche 1 bis 3, **dadurch gekennzeichnet, daß** das ohmsche Element zur Trennung des ersten Zwischenknotens der positiven Versorgungsklemme einen Wert unter dem den ersten Zwischenknoten vom Kollektor des zweiten Transistors trennenden ohmschen Element aufweist.

5. Spannungsverstärker nach einem beliebigen der Ansprüche 1 bis 4, **dadurch gekennzeichnet, daß** der Wert der ohmschen Ladung des ersten Zweigs gleich der Summe der Werte der ohmschen Elemente ist, die die ohmsche Ladung des zweiten Zweigs bilden.

6. Spannungsverstärker nach einem beliebigen der Ansprüche 1 bis 5, **dadurch gekennzeichnet, daß** die ohmschen Elemente, die die Ladung der Verstärkerstufe bilden, Widerstände sind.

7. Analog/Digital-Umsetzer, für den Erhalt einer analogen Eingangsspannung differentialer Art zur Umsetzung in ein digitales Ausgangssignal bestimmt, bestehend aus:
. einem Eingangsverstärker, bestimmt für den Erhalt der analogen Eingangsspannung und die Lieferung einer analogen Ausgangsspannung,
. einer Widerstandsstufe, in Serie zwischen einer positiven und einer negativen Versorgungsklemme angeordnet, während die Widerstände dazu bestimmt sind, an ihre Zwischenknoten eine Vielzahl von sogenannten Bezugsspannungen zu liefern,
. einer Vergleicherstufe, dazu bestimmt, einen Vergleich zwischen der Ausgangsspannung des Eingangsverstärkers und einer der Bezugsspannungen durchzuführen,
. einer Speicherstufe, dazu bestimmt, die Ergebnisse der besagten Vergleiche zu speichern,
. einem binären Kodierer, dazu bestimmt, die in der Speicherstufe gespeicherten Informationen zu erhalten und das digitale Ausgangssignal des Umsetzers zu liefern,
**dadurch gekennzeichnet, daß** der Eingangsverstärker einem beliebigen der Ansprüche 1 bis 6 entspricht.
